# EUROPEAN PATENT APPLICATION

(11) **EP 2 658 357 A1**
(43) Date of publication of application: **30.10.2013**
(21) Application number: 11851519.6
(22) Date of filing: 06.12.2011
(51) Int. Cl.: H05K 3/46, H01B 1/22, H05K 1/09

(54) **MULTILAYER WIRING SUBSTRATE, PRODUCTION METHOD FOR MULTILAYER WIRING SUBSTRATE, AND VIA PASTE**

(30) Priority: 21.12.2010 JP 2010284831
(71) Applicant: Panasonic Corporation, Osaka 571-8501 (JP); Kyoto Elex Co., Ltd., Kyoto-shi Kyoto 601-8391 (JP)
(72) Inventor: HIMORI, Tsuyoshi, Osaka 540-6207 (JP); HIRAI, Shogo, Osaka 540-6207 (JP); HIGUCHI, Takayuki, Osaka 540-6207 (JP); TOMEKAWA, Satoru, Kyoto 601-8391 (JP); NAKAYAMA, Yutaka, Kyoto 601-8391 (JP)
(74) Representative: TBK
(86) International application number: PCT/JP2011/006815
(87) International publication number: WO 2012/086140

(57) **Abstract**

A multilayer wiring board having via-hole conductors which electrically connects a plurality of wirings arranged in a manner such that an insulating resin layer is placed between the wirings, wherein: the via-hole conductors each include copper, tin, and bismuth, namely, a first metal region including a link of copper particles in plane-to-plane contact with one another, the link electrically connecting the wirings, a second metal region mainly composed of one or more of tin, a tin-copper alloy, and a tin-copper intermetallic compound, and a third metal region mainly composed of bismuth; at least a part of the second metal region is in contact with the surface of the copper particles, the surface excluding the area of the plane-to-plane contact portion of the link; and the Cu, Sn, and Bi in the metal portion are of a composition having a specific weight ratio (Cu:Sn:Bi).

## Description

### [Technical Field]

The present invention relates to a multilayer wiring board formed of wirings which are arranged with an insulating resin layer interposed therebetween, the wirings being connected to one another by via-hole conductors serving as an interlayer connection therebetween. Specifically, the present invention relates to enhancing connection reliability by way of low-resistance via-hole conductors.

### [Background Art]

A conventionally-known multilayer wiring board is obtained by connecting wirings which are arranged with an insulating resin layer interposed therebetween, the wirings being connected to one another by means of interlayer connections. Known as a way to create such an interlayer connection, is use of via-hole conductors which are formed by filling a conductive paste in holes created in the insulating resin layer. Also known are via-hole conductors which are formed by filling, in place of a conductive paste, metal particles containing copper (Cu), and then fixing the metal particles to one another with use of an intermetallic compound.

Specifically, for example, Patent Literature 1 below discloses via-hole conductors having a matrix-domain structure, in which domains of Cu particles are interspersed in a CuSn compound matrix.

Also, for example, Patent Literature 2 below discloses a sinterable composition for use in forming via-hole conductors, the composition including: a high-melting-point particle-phase material that includes Cu; and a low-melting-point material selected from metals such as tin (Sn) and tin alloys. The above sinterable composition is sintered in the presence of a liquid phase or a transient liquid phase.

Also, for example, Patent Literature 3 below discloses a via-hole conductor material in which an alloy layer with a solidus temperature of 250°C or higher is formed on the outer surface of copper particles, by heating a conductive paste containing tin-bismuth (Bi) metal particles and copper particles at a temperature equal to or higher than the melting point of the tin-bismuth (Bi) metal particles. Such a via-hole conductor material is described as achieving high connection reliability, since interlayer connection is created by the alloy layers with a solidus temperature of 250°C or higher being joined to one another, thus preventing the alloy layers from melting even during heat cycling tests and reflow resistance tests.

### [Citation List]

### [Patent Literatures]

[Patent Literature 1] Japanese Laid-Open Patent Publication No. 2000-49460
[Patent Literature 2] Japanese Laid-Open Patent Publication No. Hei 10-7933
[Patent Literature 3] Japanese Laid-Open Patent Publication No. 2002-94242

### [Summary of Invention]

### [Technical Problem]

The via-hole conductor disclosed in Patent Literature 1 will be described in detail, with reference to Fig. 10. Fig. 10 is a schematic sectional view of a via hole portion of the multilayer wiring board disclosed in Patent Literature 1.

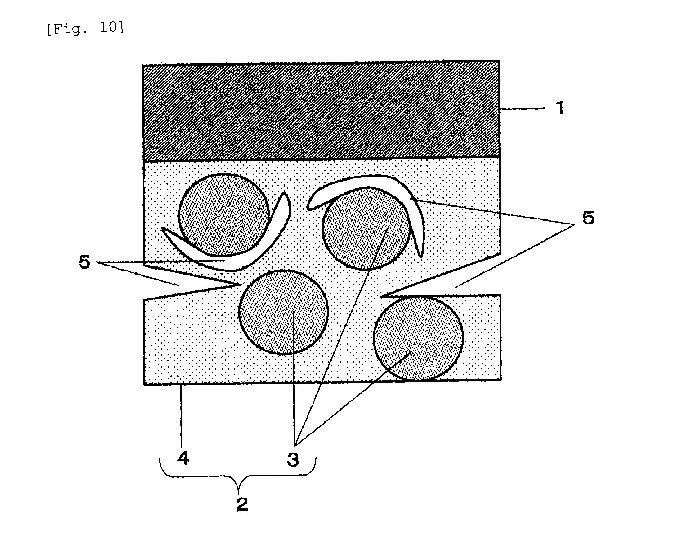

In the schematic sectional view of the multilayer wiring board of Fig. 10, a via-hole conductor 2 is in contact with a wiring 1 formed on the multilayer wiring board surface. The via-hole conductor 2 comprises: a matrix 4 including Cu₃Sn or Cu₆Sn₅ which is an intermetallic compound; and copper-containing particles 3 interspersed as domains in the matrix 4. In the via-hole conductor 2, the matrix-domain structure is formed by controlling the weight ratio represented by Sn/(Cu + Sn) to be in the range from 0.25 to 0.75. However, the above via-hole conductor 2 has the problem of being prone to voids and cracks during thermal shock tests, as those illustrated as Ref. No. 5 in Fig. 10.

The above voids and cracks are caused by a CuSn compound such as Cu₃Sn or Cu₆Sn₅ produced due to Cu diffusing into Sn-Bi metal particles when the via-hole conductor 2 is exposed to heat, during, for example, thermal shock tests or reflow processing. The above voids and cracks are also caused by internal stress generated inside the via-hole conductor 2, due to Cu₃Sn, which is an intermetallic compound of Cu and Sn included in Cu-Sn diffusion-bonded joints formed at the Cu/Sn interface, changing to Cu₆Sn₅ by heating performed during various reliability tests.

Also, the sinterable composition disclosed in Patent Literature 2 is sintered in the presence or absence of a transient liquid phase, that is generated, for example, during hot pressing performed to laminate prepregs. The above sinterable composition includes Cu, Sn, and Pb, and reaches a high temperature from 180°C to 325°C during hot pressing. Therefore, it is difficult to apply it to a typical insulating resin layer that is obtained by impregnating glass fibers with epoxy resin (this may also be called a glass/epoxy resin layer). It is also difficult to render it Pb-free as demanded by the market.

Also, in the via-hole conductor material disclosed in Patent Literature 3, the alloy layer formed on the surface of the Cu particles has high resistance. Therefore, there is the problem of higher resistance compared to connection resistance obtained only by contact among Cu particles or among Ag particles as in a typical conductive paste containing Cu particles, silver (Ag) powder, or the like.

An object of the present invention is to provide a multilayer wiring board capable of meeting the need for being Pb-free, in which interlayer connections are achieved by low-resistance via-hole conductors with high connection reliability.

### [Solution to Problem]

One aspect of the present invention is directed to a multilayer wiring board comprising:
at least one insulating resin layer;
a plurality of wirings arranged in a manner such that the insulating resin layer is placed between the wirings; and
via-hole conductors provided in a manner such that they penetrate through the insulating resin layer and electrically connect the wirings,
wherein the via-hole conductors each have a metal portion and a resin portion,
the metal portion comprises copper (Cu), tin (Sn), and bismuth (Bi), namely: a first metal region including a link of copper particles, the link electrically connecting the wirings to each other via plane-to-plane contact portions, the plane-to-plane contact portions each being created by the copper particles coming into plane-to-plane contact with each other; a second metal region mainly composed of one or more of tin, a tin-copper alloy, and a tin-copper intermetallic compound; and a third metal region mainly composed of bismuth,
at least a part of the second metal region is in contact with the surface of the link of the copper particles, the surface excluding the area of the plane-to-plane contact portion,
in a ternary plot, the weight ratio of the composition of Cu, Sn, and Bi (Cu:Sn:Bi) in the metal portion, is in a region outlined by a quadrilateral with vertices of A (0.37:0.567:0.063), B (0.22:0.3276:0.4524), C (0.79:0.09:0.12), and D (0.89:0.10:0.01), and
the plane-to-plane contact portion is created by deformations of the adjacent copper particles.

Also, another aspect of the present invention is directed to a method for producing a multilayer wiring board comprising the steps of:
perforating a resin sheet covered with a protective film to create through-holes, the perforation starting from the outer side of the protective film;
filling the through-holes with a via paste;
removing the protective film after the filling, to reveal protrusions each being a part of the via paste protruding from the through-hole;
disposing copper foil on a surface of the resin sheet, to cover the protrusions;
compression bonding the metal foil onto the surface of the resin sheet; and
heating the resultant at a predetermined temperature after the compression bonding (further preferably while maintaining the compression-bonded state),
wherein the via paste comprises copper particles, Sn-Bi solder particles, and a thermally curable resin, and in a ternary plot, the weight ratio of the composition of Cu, Sn, and Bi (Cu:Sn:Bi) is in a region outlined by a quadrilateral with vertices of A (0.37:0.567:0.063), B (0.22:0.3276:0.4524), C (0.79:0.09:0.12), and D (0.89:0.10:0.01),
in the compression bonding step, the via paste is compressed by pressure applied thereto by way of the protrusions having the metal foil disposed thereon, thereby forming a first metal region including a link of the copper particles which are electrically connected via plane-to-plane contact portions each created by deformations of the adjacent copper particles, and
in the heating step: the compressed via paste is heated to melt a part of the Sn-Bi solder particles at a temperature in a range from the eutectic temperature of the Sn-Bi solder particles, to the eutectic temperature plus 10°C; and then, the resultant is heated at a temperature in a range from the eutectic temperature of the Sn-Bi solder particles plus 20°C, to 300°C, thereby forming a second metal region mainly composed of one or more of tin, a tin-copper alloy, and a tin-copper intermetallic compound on the surface of the link of the copper particles, the surface excluding the area of the plane-to-plane contact portion; and a third metal region mainly composed of bismuth.

Also, still another aspect of the present invention is directed to a via paste for use in forming via-hole conductors in a multilayer wiring board,
wherein the multilayer wiring board has: at least one insulating resin layer; a plurality of wirings arranged in a manner such that the insulating resin layer is placed between the wirings; and via-hole conductors provided in a manner such that they penetrate through the insulating resin layer and electrically connect the wirings,
the via-hole conductors each have a metal portion and a resin portion,
the metal portion comprises copper (Cu), tin (Sn), and bismuth (Bi), namely: a first metal region including a link of copper particles, the link electrically connecting the wirings to each other via plane-to-plane contact portions, the plane-to-plane contact portions each being created by the copper particles coming into plane-to-plane contact with each other; a second metal region mainly composed of one or more of tin, a tin-copper alloy, and a tin-copper intermetallic compound; and a third metal region mainly composed of bismuth,
at least a part of the second metal region is in contact with the surface of the link of the copper particles, the surface excluding the area of the plane-to-plane contact portion, and
the via paste includes copper particles, Sn-Bi solder particles, and a thermally curable resin, and in a ternary plot, the weight ratio of Cu, Sn, and Bi (Cu:Sn:Bi) is in a region outlined by a quadrilateral with vertices of A (0.37:0.567:0.063), B (0.22:0.3276:0.4524), C (0.79:0.09:0.12), and D (0.89:0.10:0.01).

The object, features, aspects, and advantages of the present invention will become more apparent by referring to the following detailed description and accompanying drawings.

### [Advantageous Effects of Invention]

According to the present invention, low-resistance interlayer connections can be achieved by the copper particles, which are included in the via-hole conductors of the multilayer wiring board, coming into plane-to-plane contact with one another to form low-resistance conduction paths. Also, the link of the copper particles, which have the plane-to-plane contact portions where the copper particles come into plane-to-plane contact with one another, are formed; and further, on the surface of the link, there is the first metal region mainly composed of tin, a tin-copper alloy, and/or a tin-copper intermetallic compound being harder than the copper particles, thereby strengthening the link of the copper particles. Thus, reliability of electrical connection is enhanced.

### [Brief Description of Drawings]

Fig. 1A is a schematic sectional view of a multilayer wiring board 11 in an embodiment according to the present invention.
Fig. 1 B is an enlarged schematic sectional view showing the vicinity of a via-hole conductor 14 in Fig. 1 A.
Fig. 2 is an explanatory drawing describing, with respect to first metal regions 17 comprising a number of Cu particles 7, a conductive path 23 created by one of links 17a each formed by the Cu particles 7 coming into plane-to-plane contact with one another.
Fig. 3A is a sectional view of a step describing one example of a method for producing the multilayer wiring board.
Fig. 3B is a sectional view of a step subsequent to the step of Fig. 3A.
Fig. 3C is a sectional view of a step subsequent to the step of Fig. 3B.
Fig. 3D is a sectional view of a step subsequent to the step of Fig. 3C.
Fig. 4A is a sectional view of a step subsequent to the step of Fig. 3D.
Fig. 4B is a sectional view of a step subsequent to the step of Fig. 4A.
Fig. 4C is a sectional view of a step subsequent to the step of Fig. 4B.
Fig. 5A is a sectional view of a step subsequent to the step of Fig. 4C.
Fig. 5B is a sectional view of a step subsequent to the step of Fig. 5A.
Fig. 5C is a sectional view of a step subsequent to the step of Fig. 5B.
Fig. 6A is a schematic sectional view describing the state prior to compressing a via paste 28 that is filled in a through-hole in a resin sheet 25, in the embodiment.
Fig. 6B is a schematic sectional view describing the state subsequent to compressing the via paste 28 that is filled in the through-hole in the resin sheet 25, in the embodiment.
Fig. 7 is a ternary plot showing the compositions of Cu, Sn, and Bi in the embodiment and Examples.
Fig. 8A is a scanning electron microscope (SEM) image at 3000-times magnification, of a vertical section of a via conductor in a multilayer wiring board, obtained in one of the Examples.
Fig. 8B is a tracing of the SEM image of Fig. 8A.
Fig. 9A is an SEM image at 6000-times magnification, of a vertical section of a via conductor in a multilayer wiring board, obtained in the one of the Examples.
Fig. 9B is a tracing of the SEM image of Fig. 9A.
Fig. 10 is a schematic sectional view describing a vertical section of a conventional via-conductor.

### [Description of Embodiments]

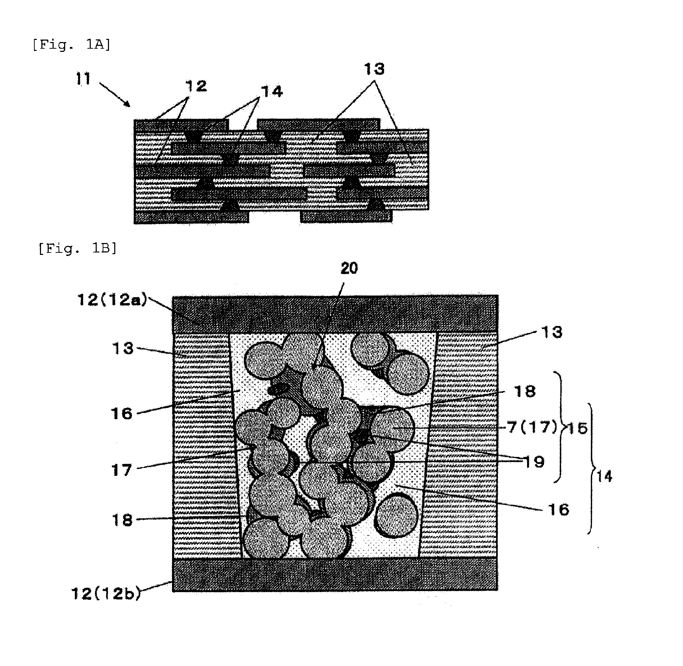

Fig. 1 A is a schematic sectional view of a multilayer wiring board 11 of the present embodiment. Also, Fig.1 B is an enlarged schematic view showing the vicinity of a via-hole conductor 14 in the multilayer wiring board of Fig. 1A.

As illustrated in Fig. 1 A, in a multilayer wiring board 11, wirings 12 formed of metal foil such as copper foil are electrically connected to one another by via-hole conductors 14 serving as interlayer connections. The wirings 12 are formed three-dimensionally on insulating resin layers 13 and the via hole conductors 14 penetrate through the insulating resin layers 13.

Fig. 1 B is an enlarged schematic sectional view showing the vicinity of the via-hole conductor 14. In Fig.1 B, Ref. No. 12 (12a, 12b) denotes the wirings, Ref. No. 13 denotes the insulating resin layer, and Ref. No. 14 denotes the via-hole conductor. The via-hole conductor 14 comprises metal portions 15 and resin portions 16. The metal portions 15 comprise: first metal regions 17 formed from a number of Cu particles 7; second metal regions 18 mainly composed of at least one metal selected from the group consisting of tin, a tin-copper alloy, and a tin-copper intermetallic compound; and third metal regions 19 mainly composed of Bi. At least a part of the Cu particles 7 forms links thereof, by being in contact with and thus linked to one another via plane-to-plane contact portions 20 where the copper particles 7 directly come into plane-to-plane contact with one another. These links serve as low-resistance conduction paths that electrically connect the upper wiring 12a and the lower wiring 12b.

The average particle size of the Cu particles 7 is preferably 0.1 to 20 µm and further preferably 1 to 10 µm. When the average particle size of the Cu particles 7 is too small, there tends to be higher conductive resistance in the via-hole conductor 14 due to increased contact among the particles therein. Also, particles of the above size tend to be costly. In contrast, when the average particle size of the Cu particles 7 is too large, there tends to be difficulty in increasing the filling rate when forming the via-hole conductors 14 with a smaller diameter, such as 100 to 150 µmϕ.

Purity of the Cu particles 7 is preferably 90 mass% or higher and further preferably 99 mass% or higher. The higher the purity, the softer the Cu particles 7 become. Thus, in a pressurization step that will be described later, the Cu particles 7 are easily pressed against one another, thereby ensuring increased area of contact among the particles due to the particles easily deforming when coming into contact with one another. Higher purity is also preferable in terms of enabling lower resistance of the Cu particle 7.

Herein, plane-to-plane contact between the copper particles, is not a state where the copper particles are in contact with each other to the extent of merely touching each other, but is a state where the adjacent copper particles are in contact with each other at their respective surfaces due to being pressurized and compressed and thus plastically deformed, resulting in increased contact therebetween. As such, by the copper particles becoming plastically deformed and thus adhered to each other, the plane-to-plane contact portion therebetween are maintained and also protected by the second metal region, even after release of compressive stress. Note that the average particle size of the Cu particles 7, and also, the plane-to-plane contact portions 20 where the Cu particles 7 come into plane-to-plane contact with one another, are identified and measured by observing a sample with use of a scanning electron microscope (SEM). The sample is created by embedding a formed multilayer wiring board in resin and then polishing vertical sections of the via-hole conductors 14. Microfabrication means such as focused ion beam may also be used as necessary.

A number of the Cu particles 7 are brought into plane-to-plane contact with one another to form low-resistance conduction paths between the wirings 12a and 12b. As above, by allowing plane-to-plane contact among a number of the Cu particles 7, it is possible to reduce connection resistance between the wirings 12a and 12b.

Also, in the via-hole conductors 14, it is preferable that the links with low resistance are formed to have a complicated network, by allowing a number of the Cu particles 17 to be in random contact with one another, rather than in orderly arrangement. Formation of the above network by the links enables a more reliable electrical connection. It is also preferable that a number of the Cu particles 7 are in plane-to-plane contact with one another at random positions. By allowing the Cu particles 7 to be in plane-to-plane contact with one another at random positions, the resulting deformation of the particles enables dispersion of stress caused within the via-hole conductors 14 at times of exposure to heat, as well as dispersion of external force that is applied from the outside.

The proportion by weight of the Cu particles 7 included in the via-hole conductors 14 is preferably 20 to 90 wt% and further preferably 40 to 70 wt%. When the proportion by weight of the Cu particles is too small, the links formed of a number of the Cu particles 7 in plane-to-plane contact with one another, are prone to become less reliable as conduction paths to provide electrical connection; and when too large, the resistance value is prone to fluctuate during reliability tests.

As illustrated in Fig. 1 B, at least a part of the second metal region 18 mainly composed of at least one metal selected from the group consisting of tin, a tin-copper alloy, and a tin-copper intermetallic compound, is formed so that it is in contact with the surface of the first metal region 17, the surface excluding the area of the plane-to-plane contact portion 20. By forming the second metal region 18 in the above manner, that is, on the surface of the first metal region 17 where the area of the plane-to-plane contact portion 20 is excluded, the first metal region 17 is strengthened. Also, at least a part of the second metal region 18 preferably extends astride the plane-to-plane contact portion 20 where the copper particles 7 are in plane-to-plane contact with each other. By forming the second metal region 18 in the above manner such that it extends astride the plane-to-plane contact portion 20, connection by the plane-to-plane contact portion is further strengthened.

The second metal regions 18 are mainly composed of at least one metal selected from the group consisting of tin, a tin-copper alloy, and a tin-copper intermetallic compound. Specifically, for example, they are mainly composed of a simple substance of Sn, Cu₆Sn₅, Cu₃Sn, or the like. Also, for the remainder, other metals such as Bi and Cu may be included to the extent of not ruining the effect of the present invention, that is, specifically in the range of, for example, 10 mass% or less.

Also, as illustrated in Fig. 1 (B), in the metal portions 15, the third metal regions 19 mainly composed of Bi are preferably present in a manner such that they are not in contact with the Cu particles 7, but are in contact with the second metal regions 18. In the via-hole conductor 14, the third metal regions 19 not in contact with the Cu particles 7 do not reduce conductivity of the first metal regions 17. Also, in the via-hole conductor 14, the proportion of the third metal regions 19 is preferably as small as possible. This is because the third metal regions 19 mainly composed of Bi have relatively high resistance.

The third metal regions 19 are mainly composed of Bi. Also, for the remainder, an alloy, intermetallic compound, or the like, of Bi and Sn, may be included to the extent of not ruining the effect of the present invention, that is, specifically in the range of, for example, 20 mass% or less.

Note that since the second metal regions 18 and the third metal regions 19 are in contact with one another, they normally include both Bi and Sn. In this case, the second metal regions 18 have a higher Sn concentration than the third metal regions 19, while the third metal regions 19 have a higher Bi concentration than the second metal regions 18. In addition, it is preferred that the interface between the second metal region 18 and the third metal region 19 is not definite than being definite. When the interface is not definite, it is possible to prevent stress from concentrating at the interface even under heating conditions for thermal shock tests or the like.

The metal portions 15 included in the via-hole conductor 14 as above comprise: the first metal regions 17 composed of the copper particles 7; the second metal regions 18 mainly composed of at least one metal selected from the group consisting of tin, a tin-copper alloy, and a tin-copper intermetallic compound; and the third metal regions 19 mainly composed of bismuth.

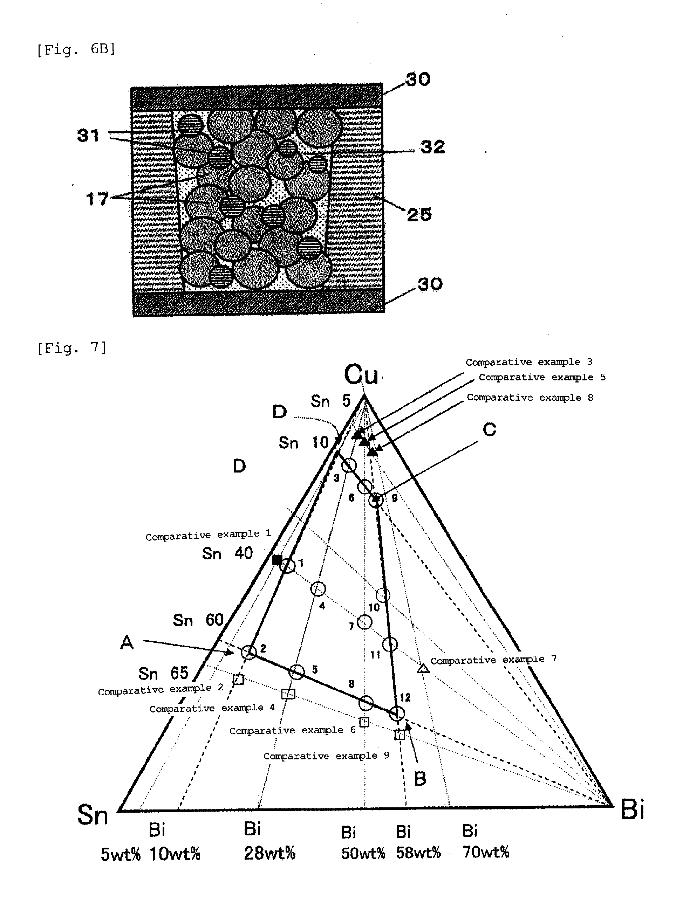

Also, in a ternary plot as that of Fig. 7 showing the weight ratio of the composition of Cu, Sn, and Bi (Cu:Sn:Bi), the composition of the metal portion 15 is in a region outlined by a quadrilateral with vertices of A (0.37:0.567:0.063), B (0.22:0.3276:0.4524), C (0.79:0.09:0.12), and D (0.89:0.10:0.01). When the composition of the metal portion 15 is in the above range, the via-hole conductor has a low resistance value and is highly reliable relative to thermal history.

Note that with respect to the above range, in the case where the proportion of Bi relative to Sn is too large, the proportion of the third metal regions mainly composed of Bi increases when forming the via-hole conductor, resulting in higher resistance value, and also, lower connection reliability relative to thermal history according to the manner in which the third metal regions are interspersed. In the case where the proportion of Bi relative to Sn is too small, it would be necessary to melt the solder components at a high temperature when forming the via-hole conductor. Also, in the case where the proportion of Sn relative to the Cu particles is too large, the copper particles may not sufficiently come into plane-to-plane contact with one another; or a layer of a Sn-Cu compound or the like that has high resistance, may be easily formed at the contact plane between the copper particles. In the case where the proportion of Sn relative to the Cu particles is too small, the second metal regions which come into contact with the surfaces of the links of the copper particles become less, resulting in lower reliability relative to thermal history.

On the other hand, the resin portions 16 included in the via-hole conductor 14 are made of cured material of curable resin. The curable resin is not particularly limited, but specifically, for example, a cured epoxy resin is particularly preferred in terms of excellent heat resistance and lower linear expansion coefficient.

The proportion by weight of the resin portions 16 in the via-hole conductor 14 is preferably 0.1 to 50 wt%, and further preferably 0.5 to 40 wt%. When the proportion by weight of the resin portions 16 is too large, resistance tends to increase, and when too small, preparation of a conductive paste tends to be difficult.

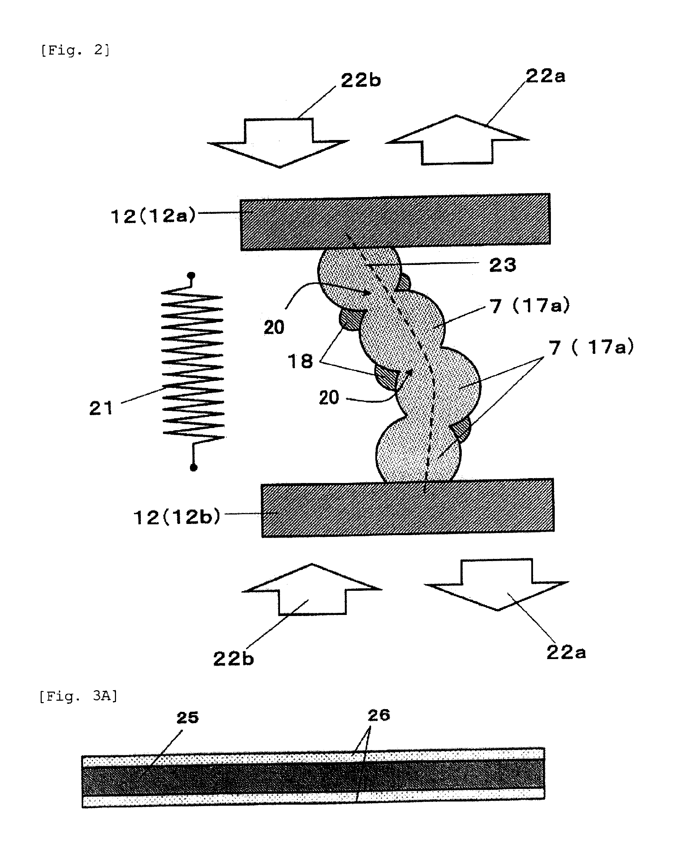

Next, the effect of the via-hole conductors 14 in the multilayer wiring board 11 will be schematically described with reference to Fig. 2.

Fig. 2 is an explanatory drawing for providing a description with focus on a conduction path 23 created by one of links 17a each formed by a number of the Cu particles 7 being in plane-to-plane contact with one another. Also, for convenience, the resin portions 16, etc. are not illustrated. Furthermore, "21" denotes a virtual spring illustrated for convenience in describing the effect of the via-hole conductor 14.

As illustrated in Fig. 2, the link 17a, which is formed by a number of the Cu particles 7 randomly coming into plane-to-plane contact with one another, forms the conductive path 23 for creating an electrical interlayer connection between the wirings 12a and 12b. Note that at the plane-to-plane contact portion 20 where the Cu particles 7 are in contact with each other, the second metal region 18 is preferably formed in a manner such that it covers around, and extends astride, the plane-to-plane contact portion 20.

When internal stress occurs inside the multilayer wiring board 11, force, which is outwardly directed as indicated by arrows 22a, is applied inside the multilayer wiring board 11. Such internal stress occurs, for example, at the time of solder reflow or thermal shock tests, due to the differing thermal expansion coefficients among materials which compose the individual components.

Such outwardly-directed force is reduced by factors such as: deformation of the highly flexible Cu particles 7 themselves; elastic deformation of the link 17a formed by the Cu particles 7 coming into contact with one another; or slight shift in the plane-to-plane contact positions among the Cu particles 7. At this time, the second metal regions 18 have a hardness that is greater than that of the Cu particles 7, and thus tend to resist deformation of the link 17a, particularly at the plane-to-plane contact portions 20. Therefore, in the case where the plane-to-plane contact portion 20 between the Cu particles 17 tends to keep on deforming without limitation, it does not deform to the point of the plane-to-plane contact portion 20 being divided, since the second metal portion 18 regulates the deformation to a certain extent. With respect to the above, in the case where the link 17a formed by the Cu particles 7 being in contact with one another is likened to a spring, when a certain amount of force is applied to the link 17a, the link 17a keeps on deforming to a certain extent as if the spring is stretched; but when the deformation of the link 17a is likely to become greater, it is regulated by the hard second metal regions 18. A similar effect as above is also achieved when force, which is directed inwardly as indicated by arrows 22b, is applied to the multilayer wiring board 11. Thus, it is possible to ensure reliability of electrical connection, due to the link 17a acting as if it was the spring 21 and enabling regulation of deformation of the link 17a against forces in any direction, whether external or internal.

Next, to describe an exemplary method for producing the aforementioned multilayer wiring board 11, each step for the production will be described in detail with reference to the drawings.

In the production method of the present embodiment, first, as illustrated in Fig. 3A, protective films 26 are attached to both surfaces of a resin sheet 25. The resin sheet 25 may be an insulating material conventionally used in producing wiring boards, examples thereof including, but not particularly limited to: a resin sheet which is a laminate made of a heat-resistant resin sheet with an uncured resin layer laminated on both surfaces thereof (hereinafter referred to as a heat-resistant resin sheet including uncured layers); a heat-resistant thermoplastic resin sheet; and an uncured or semi-cured (B-stage) prepreg. Particularly preferred among the above is the heat-resistant resin sheet including uncured layers, in terms of its enabling obtaining of a thin multilayer wiring board. Specifically, when the heat-resistant resin sheet including uncured layers is used, even if its thickness is, for example, 15 µm or less, or even 6 µm or less, it would be possible to form an insulating resin layer having sufficient insulating properties. With respect to the present embodiment, a case of representatively using the heat-resistant resin sheet including uncured layers will be described in detail.

The heat-resistant resin sheet including uncured layers comprises: a heat-resistant resin film; and an uncured resin layer laminated on at least one surface of, and preferably both surfaces of, the heat-resistant resin film. The uncured resin layer allows attachment of metal foil and a formed wiring.

The heat-resistant resin sheet may be any resin sheet without particular limitation, as long as it is resistant to soldering temperatures. Specific examples thereof include a polyimide film, a liquid crystal polymer film, and a polyether ether ketone film. Particularly preferred among the above is the polyimide film. The heat-resistant resin sheet preferably has a thickness of 1 to 100 µm, further preferably 3 to 75 µm, and particularly preferably 7.5 to 60 µm.

An example of the uncured resin layer is an adhesive layer that is uncured and made of an epoxy resin or the like. Also, the thickness of the uncured resin layer per surface of the heat-resistant resin film is preferably 1 to 30 µm and further preferably 5 to 10 µm, in terms of contributing to make the multilayer wiring board thinner.

The protective film may be any resin film. Specific examples thereof include resin films of PET (polyethylene terephthalate), PEN (polyethylene naphthalate), and the like. The thickness of the resin film is preferably 0.5 to 50 µm and further preferably 1 to 30 µm. In the case of the above thickness, it is possible to reveal protrusions made from a via paste and of a sufficient height, by removing the protective films. This will be described later.

An example of a method for attaching the protective films 26 to the resin sheet 25, is a method in which the films are directly attached to the sheet with use of tackiness of the uncured or semi-cured surface of the uncured resin layer.

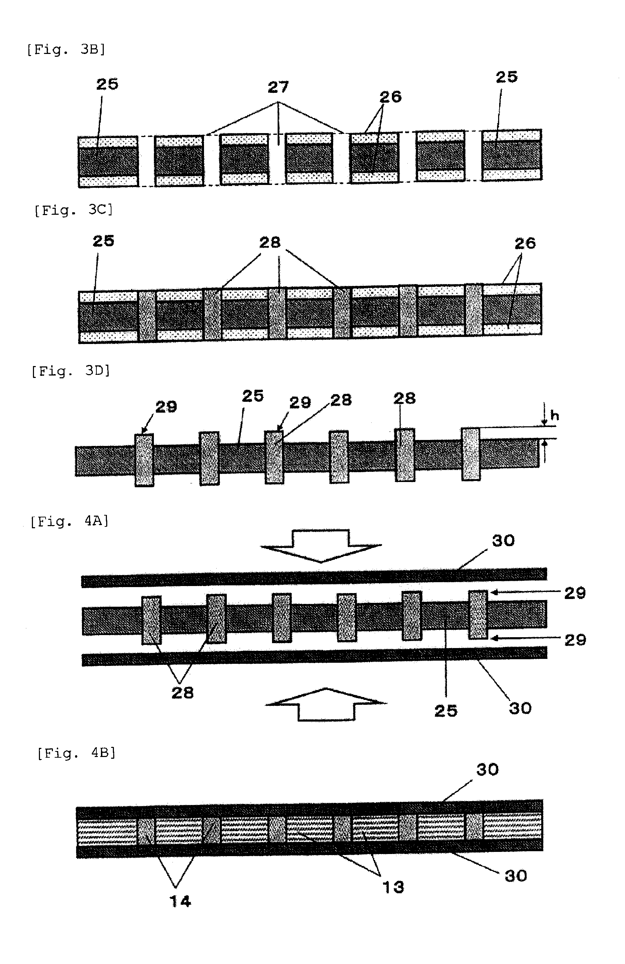

Next, as illustrated in Fig. 3B, through-holes 27 are created by perforating the resin sheet 25 with the protective films 26 disposed thereon, starting from the outside of either one of the protective films 26. For the perforation, various methods such as drilling holes, etc. can be used, in addition to a non-contact processing method using a carbon dioxide gas laser, a YAG laser, or the like. The through-holes can have a diameter of 10 to 500 µm, or even about 50 to 300 µm.

Next, as illustrated in Fig. 3(C), via paste 28 is fully filled into the through-holes 27. The via paste 28 contains Cu particles, Sn-Bi solder particles containing Sn and Bi, and a curable resin component such as an epoxy resin.

The average particle size of the Cu particles is preferably in the range from 0.1 to 20 µm, and further preferably from 1 to 10 µm. In the case where the average particle size of the Cu particles is too small, it is difficult for the through-holes 27 to be highly filled, and it also tends to be costly. On the other hand, in the case where the average particle size of the Cu particles is too large, filling tends to be difficult when forming via-hole conductors 14 with a smaller diameter.

Also, the Cu particles are not particularly limited to any particle form, and may specifically be, for example, spherical, flat, polygonal, scale-like, flake-like, in a form with surface projections, or the like. Furthermore, the particles may be primary particles, or may be secondary particles.

The Sn-Bi solder particles are solder particles containing Sn and Bi, but are not particularly limited thereto, as long as they have a composition in which the weight ratio of Cu, Sn, and Bi in the paste can be adjusted to be in a region outlined by a quadrilateral with vertices of A, B, C, and D in a ternary plot as shown in aforementioned Fig. 7. Also, the Sn-Bi solder particles may be improved in wettability, flowability, etc., by having indium (In), silver (Ag), zinc (Zn), or the like added thereto. The Bi content in the above Sn-Bi solder particles is preferably 10 to 58%, and further preferably 20 to 58%. Furthermore, the Sn-Bi solder particles used preferably have a melting point (eutectic point) that is in the range from 75 to 160°C, and further preferably from 135 to 150°C. Note that the Sn-Bi solder particles used may be a combination of two or more different kinds of particles having different compositions. Particularly preferred among the above, are Sn-58Bi solder and the like, being environmentally-friendly lead-free solders with a low eutectic point of 138°C.

The average particle size of the Sn-Bi solder particles is preferably in the range from 0.1 to 20 µm, and further preferably 2 to 15 µm. In the case where the average particle size of the Sn-Bi solder particles is too small, melting of the particles tends to be difficult, due to increased specific surface area which results in increased proportion of an oxide film on the particle surface. On the other hand, in the case where the average particle size of the Sn-Bi solder particles is too large, the ability of the particles to fill the via holes tends to become poor.

Specific examples of the epoxy resin being the preferred curable resin component, include glycidyl ether epoxy resin, alycyclic epoxy resin, glycidyl amine epoxy resin, glycidyl ester epoxy resin, and other modified epoxy resins.

Also, a curing agent may be blended with the epoxy resin in a combination. The curing agent is not limited to any particular kind, but is particularly preferably a curing agent which contains an amine compound having at least one or more hydroxyl groups in its molecules. The above curing agent is preferable, in terms of working as a curing catalyst for the epoxy resin, and also, of having an effect of producing lower contact resistance at the time the particles join together, by reducing the oxide film that is on the surface of the Cu particles and on the surface of the Sn-Bi solder particles. Particularly preferred among the above is the amine compound with a boiling point higher than the melting point of the Sn-Bi solder particles, in terms of being highly effective, particularly in obtaining lower contact resistance at the time the particles join together.

Specific examples of the above amine compound include 2-methylaminoethanol (boiling point: 160°C), N,N-diethylethanolamine (boiling point: 162°C), N,N-dibutylethanolamine (boiling point: 229°C), N-methylethanolamine (boiling point: 160°C), N-methyldiethanolamine (boiling point: 247°C), N-ethylethanolamine (boiling point: 169°C), N-butylethanolamine (boiling point: 195°C), diisopropanolamine (boiling point: 249°C), N,N-diethylisopropanolamine (boiling point: 125.8°C), 2,2'-dimethylaminoethanol (boiling point: 135°C), triethanolamine (boiling point: 208°C), and the like.

The via paste is prepared by mixing the Cu particles, the Sn-Bi solder particles containing Sn and Bi, and the curable resin component such as the epoxy resin. Specifically, the via paste is prepared by, for example, adding the Cu particles and the Sn-Bi solder particles to a resin varnish which contains an epoxy resin, a curing agent, and a predetermined amount of an organic solvent, and then mixing the resultant with a planetary mixer or the like.

The proportion of the curable resin component to be blended, relative to the total amount of the curable resin component and the metal component including the Cu particles and Sn-Bi solder particles, is preferably in the range from 0.3 to 30 mass%, and further preferably from 3 to 20 mass%, in terms of achieving lower resistance and of ensuring sufficient workability.

Also, with respect to the blend ratio between the Cu particles and the Sn-Bi solder particles in the via paste, it is preferable that the respective contents of these two kinds of particles satisfy the weight ratio of Cu, Sn, and Bi that is in the region outlined by the quadrilateral of the vertices of A, B, C, and D, in the ternary plot shown in Fig. 7. For example, when Sn-58Bi solder particles are used as the Sn-Bi solder particles, the content of the Cu particles relative to the total amount of the Cu particles and the Sn-58Bi solder particles, is preferably 22 to 80 mass%, and further preferably 40 to 80 mass%.

The method for filling the via paste is not particularly limited. Specifically, for example, a method such as screen printing or the like is used. Note that in the production method of the present embodiment, when filling the via paste into the through-holes, it is necessary that the amount filled is to the extent that the via paste flows out from the through-holes 27 formed in the resin sheet 25, so that when the protective films 26 are removed after the filling step, the via paste 28 partially protrudes from the through-holes 27, thereby allowing protrusions to be revealed.

Next, as illustrated in Fig. 3D, the protective films 26 are removed from the surfaces of the resin sheet 25, thereby allowing the via paste 28 to partially protrude from the through-holes 27, as protrusions 29. Height "h" of the protrusions 29 depends on the thickness of the protective films, and is, for example, preferably 0.5 to 50 µm and further preferably, 1 to 30 µm. When the height of the protrusions 29 is too high, it is not preferable, since the paste may possibly overflow and spread around the through-holes 27 on the surfaces of the resin sheet 25 during a compression-bonding step that will be described later, thereby causing loss of surface smoothness. When too low, during the compression-bonding step that will be described later, pressure does not tend to be sufficiently exerted to the via paste that has been filled.

Next, as illustrated in Fig. 4A, a copper foil 30 is disposed on both surfaces of the resin sheet 25 and then pressed in directions indicated by arrows. Thus, the resin sheet 25 integrated with the copper foils 30 as illustrated in Fig. 4(B) results in formation of an insulating resin layer 13. In this case, at the beginning of the pressing, force is applied to the protrusions 29 with the copper foils 30 disposed thereon. Therefore, the via paste 28 that has been filled into the through-holes 27 is compressed under high pressure. Thus, space among the Cu particles 7 contained in the via paste 28 are narrowed, and the Cu particles 7 are compressed against one another and deformed, causing them to come into plane-to-plane contact with one another.

Pressing conditions are not particularly limited, but the mold temperature is preferably set to be in the range from room temperature (20°C) to a temperature lower than the melting point of the Sn-Bi solder particles. Also, in this pressing step, a hot press machine may be used to promote curing of the uncured resin layers, with the hot press machine heated to a temperature necessary to promote the curing.

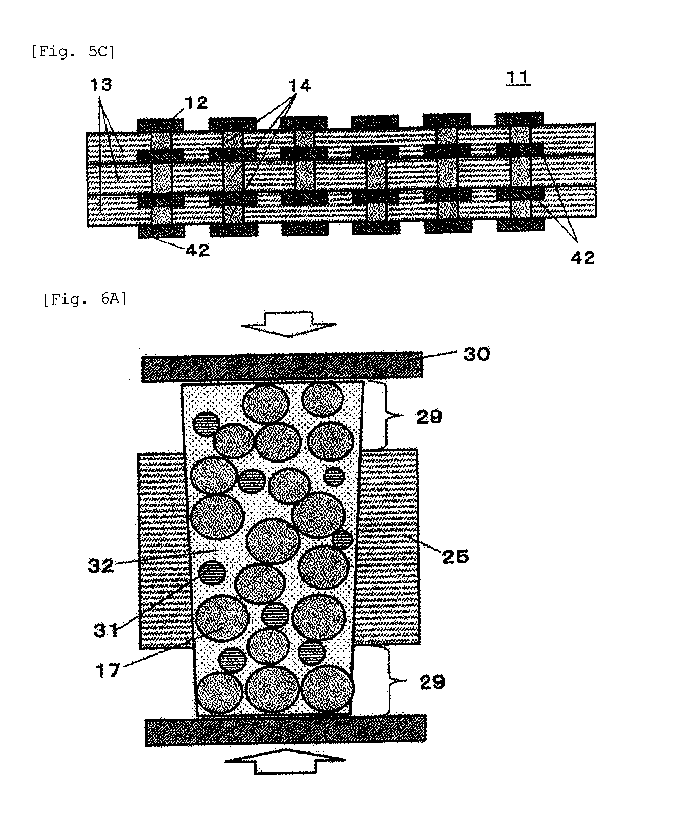

The manner in which the via paste 28 having the protrusions 29 is compressed, will now be described in detail with reference to Figs. 6A and 6B.

Figs. 6A and 6B are schematic sectional views of the vicinity of the through-hole 27 in the resin sheet 25, which is filled with the via paste 28. Also, Fig. 6A illustrates the state before the compression, and Fig. 6B illustrates the state after the compression.

As illustrated in Fig. 6A, the protrusions 29 protruding from the through-hole 27 created in the resin sheet 25 are pressed, with the copper foils 30 disposed on the protrusions 29. This causes the via paste 28 filled in the through-hole 27 to be compressed, as illustrated in Fig. 6B. Note that at this time, the curable resin component 32 may be partially forced out of the through-hole 27. As a result, the Cu particles 7 and the Sn-Bi solder particles 31 filled in the through-hole 27 increase in density, thereby causing formation of links 17a in which the Cu particles 7 are in plane-to-plane contact with one another.

The via paste is pressurized and compressed, preferably by compression bonding the metal foils onto the resin sheet, and then applying a predetermined amount of pressure to the protrusions of the via paste, the protrusions having the metal foil disposed thereon. This allows the copper particles to come into plane-to-plane contact with one another, thereby forming first metal regions including the links of the copper particles. To make the copper particles come into plane-to-plane contact, they are preferably pressurized and compressed until they are plastically deformed against one another. Also, in this compression bonding step, it is effective to perform heating (or start heating) as necessary. This is because it is effective to carry out a heating step subsequent to the compression bonding step.

Further, it is effective to partially melt the Sn-Bi solder particles by heating them at a predetermined temperature, while maintaining the above compression-bonded state. By performing heating while maintaining the compression-bonded state and thus diffusing the solder particles, it is possible to prevent molten solder or the like, or resin or the like, from entering the plane-to-plane contact portion between the copper particles. Thus, it is effective to include a heating step as a part in the compression bonding step. Also, by starting the heating in the compression bonding step, productivity can be increased since the total time of the compression bonding step and the heating step can be shortened.

Also, second metal regions mainly composed of any one or more of tin, a tin-copper alloy, and a tin-copper intermetallic compound, are each preferably formed on the surface of the link of the copper particles, the surface excluding the area of plane-to-plane contact portion, in the manner of: heating the compressed via paste while maintaining the compression, so as to partially melt the Sn-Bi solder particles at temperatures ranging from the eutectic temperature of the Sn-Bi solder particles, to the eutectic temperature plus 10°C; and then, further heating the resultant at temperatures ranging from the eutectic temperature plus 20°C, to 300°C. It is effective to designate a step comprising the above compression bonding and heating, as one step. By this one step in which the compression bonding, the heating, and the metal region formation are performed in succession, it is possible to stabilize the formation reaction of each of the above metal regions, and to stabilize the structure of the vias themselves.

The links 17a are formed by compression, and then, the via paste 28 is further heated in a gradual manner until reaching a temperature equal to or higher than the eutectic temperature of the Sn-Bi solder particles 31. By the heating, the Sn-Bi solder particles 31 partially becomes molten in an amount equal to that in which the composition becomes molten at that reached temperature. Also, the second metal regions 18 mainly composed of tin, a tin-copper alloy, and/or a tin-copper intermetallic compound are each formed on the surface of, or around, the Cu particles 7 and the links 17a. In this case, the plane-to-plane contact portion 20, where the Cu particles 7 are in plane-to-plane contact with each other, is preferably covered by the second metal region 18 in a manner such that it extends astride the portion 20. The second metal regions 18 mainly composed of a layer of a Sn-Cu compound including Cu₆Sn₅ or Cu₃Sn (intermetallic compound), or of a tin-copper alloy, are formed from the Cu particles 7 and the molten Sn-Bi solder particles 31 coming into contact with one another and causing the Cu in the Cu particles 7 and the Sn in the Sn-Bi solder particles 31 to react with one another. On the other hand, third metal regions 18 mainly composed of Bi are formed from the molten state of the Sn-Bi solder particles 31 that continue to be in a molten state while Sn is being compensated from the Sn phase in the solder particles 31 and the Bi is remaining in the solder particles 31 to be deposited. This results in obtaining of the via-hole conductors 14 having the structure as illustrated in Fig. 1 B.

More specifically, the Cu particles 7, which are made highly dense as above, come into contact with one another by compression. During the compression, first, the Cu particles 7 come into point-to-point contact with one another, and then, they are pressed against one another as pressure increases. This causes the particles to deform and to come into plane-to-plane contact with one another, resulting in formation of the plane-to-plane contact portions. A number of the Cu particles 7 coming into plane-to-plane contact with one another as described above, causes formation of the links 17a which serve to electrically connect, with low resistance, an upper wiring and a lower wiring. Also, it is possible to form the links 17a with the Cu particles 17 in direct contact with one another, due to the plane-to-plane contact portions not being covered with the Sn-Bi solder particles 31. As a result, the conduction paths formed can be reduced in electrical resistance. Subsequently, heating is performed while in the above state, and the Sn-Bi solder particles 31 start to partially melt when temperature reaches the eutectic temperature thereof or higher. The composition of the solder that melts is determined by temperature, and the Sn that does not easily melt at the temperature during the heating remains as solid phase substance. Also, when the Cu particles 7 come into contact with the molten Sn-Bi solder, and the surface of the particles gets wet with the molten solder, interdiffusion between the Cu and the Sn progresses at the interface of the wet part, resulting in formation of the Sn-Cu compound layer, or the like. As above, the second metal regions 18 are produced in a manner such that they each come in contact with the surface of the Cu particles 7, the surface excluding the area of the plane-to-plane contact portion. The second metal region 18 is partially formed in a manner such that it extends astride the plane-to-plane contact portion. As above, in the case where the second metal region 18 partially covers the plane-to-plane contact portion in a manner such that it extends astride that portion, the plane-to-plane contact portions are strengthened and the conduction path becomes highly elastic. Also, further progression in the formation of the Sn-Cu compound layer or the like, or in the interdiffusion, causes the decrease of Sn in the molten solder. This decrease of Sn in the molten solder is compensated by the Sn solid phase, and therefore, the molten state is continued to be maintained. When Sn further decreases and Bi increases with respect to the ratio between Sn and Bi in the Sn-57Bi particles, segregation of Bi begins, and the third metal regions are formed in a manner such that they are deposited as solid-phase substances mainly composed of bismuth.

Well-known solder materials that melt at relatively low temperatures include Sn-Pb solders, Sn-In solders, Sn-Bi solders, etc. Among these materials, In is costly and Pb is highly environmentally unfriendly. On the other hand, the melting point of Sn-Bi solders is 140°C or lower, which is lower than the typical solder reflow temperature used when electronic components are surface mounted. Therefore, in the case where only Sn-Bi solder is simply used for via-hole conductors of a circuit board, there is a possibility of varied via resistance due to the solder in the via-hole conductors remelting at the time of solder reflow. On the other hand, with respect to the metallic composition of the via paste of the present embodiment, the weight ratio of the composition of Cu, Sn, and Bi (Cu:Sn:Bi) is, in a ternary plot, in a region outlined by a quadrilateral with vertices of A (0.37:0.567:0.063), B (0.22:0.3276:0.4524), C (0.79:0.09:0.12), and D (0.89:0.10:0.01). In the case of using the via paste of the above metallic composition, that is, when using the via paste in which the composition of the Sn-Bi solder particles has a larger Sn content compared to the composition of eutectic Sn-Bi solder (Bi: 57% or less, Sn: 43% or more), a part of the solder composition melts at a temperature in the range of the eutectic temperature of the Sn-Bi solder particles plus 10°C, or lower, while Sn that fails to melt remains; however, the remaining Sn also melts, as the Sn concentration in the Sn-Bi solder particles becomes lower depending on Sn diffusion at, and Sn reaction with, the surface of the Cu particles. At the same time, Sn melts also due to a rise in temperature by continued heating, thus resulting in disappearance of Sn in the solder composition that had failed to melt. With the heating further continued and with further progression of the reaction of Sn and the Cu particle surface, the third metal regions as solid phase substances mainly composed of bismuth are formed. Also, by allowing the third metal regions to be deposited and thus be present as above, remelting of the solder in the via-hole conductors becomes unlikely, even under solder reflow. Furthermore, use of a Sn-Bi composition solder powder with a much larger Sn content enables reduction of the Bi phase remaining in the via, thus enabling stabilization of resistance and prevention of varied resistance even after solder reflow.

The temperature for heating the via paste 28 after the compression is not particularly limited, as long as it is equal to or higher than the eutectic temperature of the Sn-Bi solder particles 31 and is within a temperature range that does not allow decomposition of the components of the resin sheet 25. Specifically, for example, in the case of using as the Sn-Bi solder particles, the Sn-58Bi solder particles having an eutectic temperature of 139°C, it is preferable that: first, the Sn-58Bi solder particles are heated to a temperature in the range from 139 to 149°C so as to melt a part of the particles; and then, further heated in a gradual manner to a temperature in the range from about 159 to 230°C. Note that by appropriately selecting the temperature at this time, it is possible to cure the curable resin component included in the via paste 28.

In this manner, the via-hole conductors 14 serving as an interlayer connection between an upper wiring 12a and a lower wiring 12b, are formed.

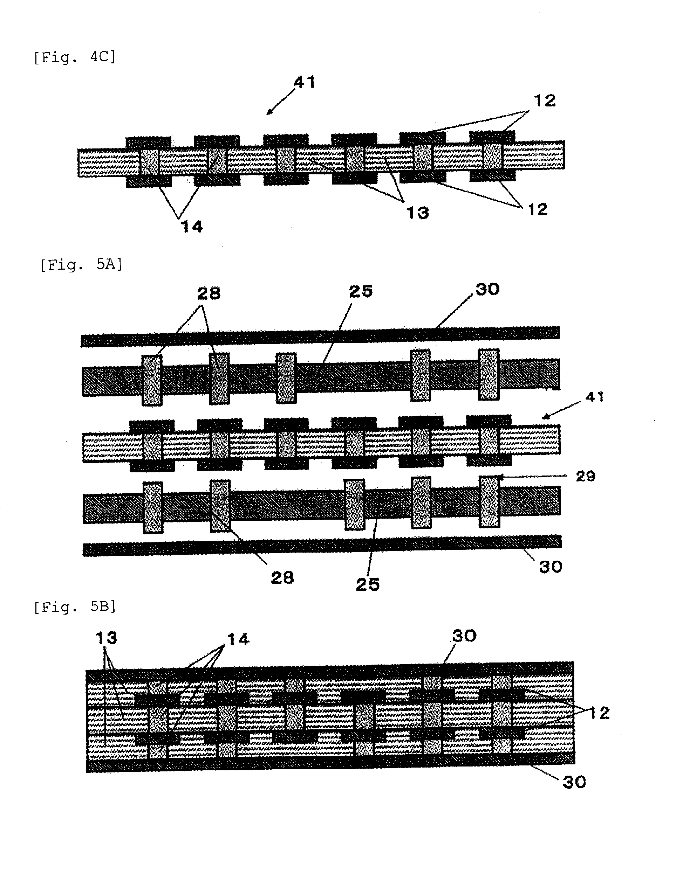

Next, wirings 12 are formed as illustrated in Fig. 4C. The wirings 12 are each formed by: forming a photoresist film on the surface of the copper foil 30 that is attached to the surface layer; patterning the photoresist film by selective exposure through a photomask; developing the photoresist film; etching the resultant to remove the copper foil in a selective manner, that is, to remove the copper other than the wiring portions; and then, removing the photoresist film. A liquid resist or a dry film may be used to form the photoresist film.

The above step results in obtaining a wiring board 41 having circuits formed on both surfaces including the upper wiring 12a and the lower wiring 12b that are connected via the via-hole conductors 14. Further, by multilayering the above wiring board 41, a multilayer wiring board 11 in which interlayer connections are created among layers of circuits, as illustrated in Fig. 1 A, is obtained. The manner in which the wiring board 41 is multilayered, will be described with reference to Fig. 5.

First, as illustrated in Fig. 5A, the resin sheet 25 having the protrusions 29 made of the via paste 28 that is obtained in the same manner as in Fig. 4D, is disposed on both surfaces of the wiring board 41 obtained as described above. Further, a copper foil 30 is disposed on the outer surface of each of the resin sheets 25, thereby forming a stacked structure. Then, the stacked structure is placed into a mold for pressing, followed by pressing and heating under the conditions as described above to obtain a laminate as illustrated in Fig. 5B. Then, new wirings 42 are formed by performing the photo processing as described above. By additionally repeating the above multilayering process, a multilayer wiring board 11 as illustrated in Fig. 5C is obtained.

### [Examples]

Next, the present invention will be described more specifically by way of Examples. Note that the contents of the Examples are not to be in any way construed as limiting the scope of the present invention.

### [Examples 1 to 12 and Comparative Examples]

First, a description will be given on all of the raw materials used in the present Examples.
- Cu particles: "1100Y" with an average particle size of 5 µm, available from Mitsui Mining & Smelting Co., Ltd.
- Sn-Bi solder particles were obtained by: blending materials so as to obtain the respective solder compositions in Table 1, listed according to compositions; melting the resultant; making the resultant into powder form by atomization; and then classifying the resultant so that the average particle size is 5 µm.
- Epoxy resin: "jeR871" available from Japan Epoxy Resin K.K.
- Curing agent: 2-methylaminoethanol with a boiling point of 160°C, available from Nippon Nyukazai Co., Ltd.
- Resin sheet: a 75 µm-thick, 500 mm (height) x 500 mm (width) polyimide film, with a 12.5 µm-thick uncured epoxy resin layer laminated on both surfaces of the film
- Protective film: a 25 µm-thick PET sheet
- Copper foil (thickness: 25 µm)

### (Preparation of via paste)

Metallic components of the Cu particles and the Sn-Bi solder particles at a blend ratio as in Table 1; and resin components of the epoxy resin and the curing agent were blended, and then mixed with a planetary mixer, thereby preparing a via paste. The blend ratio of the resin components was 10 parts by weight of the epoxy resin and 2 parts by weight of the curing agent, both relative to a total of 100 parts by weight of the copper powder and the Sn-Bi solder particles.

### (Production of Multilayer Wiring Board)

The protective film was attached to both surfaces of the resin sheet. Then, by using a laser from the outer side of the protective films attached thereto, 100 or more perforations having a diameter of 150 µm were created.
Next, the prepared via paste was fully filled into the through-holes. Then, the protective films on the both surfaces were removed, thereby revealing protrusions formed by the via paste partially protruding from the through-holes.
Next, the copper foil was disposed on the both surfaces of the resin sheet, so as to cover the protrusions. Then, a laminate of the copper foil and the resin sheet was placed on the lower mold of a pair of molds for heat pressing, with an exfoliate paper placed between the laminate and the mold, and heat pressing was performed. The temperature for the heat pressing was increased from a room temperature of 25 degrees to a maximum temperature of 220°C in 60 minutes, kept at 220°C for 60 minutes, and then cooled down to the room temperature in 60 minutes. Note that the pressure for the pressing was 3 MPa. In this manner, a multilayer wiring board was obtained.

### (Evaluation)

### <Resistance Test>

The 100 via-hole conductors formed in the obtained multilayer wiring board were measured for resistance by a four-terminal method. Then, values for initial resistance and maximum resistance were obtained respectively for each of the 100 via-hole conductors. Note that for the initial resistance, values equal to or lower than 2 mΩ were evaluated as "A" and values exceeding 2 mΩ were evaluated as "B". Also, for the maximum resistance, values lower than 3 mΩ were evaluated as "A", and values higher than 3 mΩ were evaluated as "B".

### <Connection Reliability>

The multilayer wiring board measured for initial resistance was subjected to a thermal cycle test of 500 cycles. The via-hole conductors with 10% or lower percent of change from the initial resistance was evaluated as "A", and those with higher than 10% of change from the initial resistance was evaluated as "B".

The results are shown in Table 1. Also, Fig. 7 shows a ternary plot depicting the respective compositions of the Examples and Comparative Examples, as listed in Table 1. Note that in the ternary plot of Fig. 7, a "circle" depicts the respective compositions of the Examples; a "darkened square" depicts the composition of Comparative Example 1 in which the Bi amount relative to the Sn amount is smaller compared to the metallic composition according to the present invention; a "triangle" depicts the composition of Comparative Example 7 in which the Bi amount relative to the Sn amount is larger compared to the metallic composition according to the present invention; a "square" depicts the respective compositions of Comparative Examples 2, 4, 6, and 9 in which the Sn amount relative to the Cu amount is larger than the metallic composition according to the present invention; and a "darkened triangle" depicts the respective compositions of Comparative Examples 3, 5, and 8 in which the Sn amount relative to the Cu amount is smaller compared to the metallic composition according to the present invention.

**[Table 1]**

| Example No. | Metallic composition | | | | Resistance [mΩ] | Maximum resistance [mΩ] | Evaluation | | | Plot in Fig. 7 |
|---|---|---|---|---|---|---|---|---|---|---|
| | Weight ratio of composition | Solder composition | Cu particles [wt%] | Solder amount [wt%] | | | Initial resistance | Maximum resistance | Connection reliability | |
| Comp. Ex. 1 | 0.59:0.3895:0.0205 | Sn-5Bi | 59 | 41 | 1.01 | 1.25 | A | A | B | ■ |
| 1 | 0.57:0.387:0.043 | Sn-10Bi | 57 | 43 | 1.3 | 1.42 | A | A | A | ○ |
| 2 | 0.37:0.567:0.063 | Sn-10Bi | 37 | 63 | 1.8 | 1.99 | A | A | A | ○ |
| Comp. Ex. 2 | 0.33:0.603:0.067 | Sn-10Bi | 33 | 67 | 2.1 | 2.51 | B | A | A | □ |
| Comp. Ex. 3 | 0.93:0.0504:0.0196 | Sn-28Bi | 93 | 7 | 0.91 | 1.8 | A | A | B | ▲ |
| 3 | 0.87:0.0504:0.0196 | Sn-28Bi | 87 | 13 | 0.99 | 1.1 | A | A | A | ○ |
| 4 | 0.52:0.3456:0.1344 | Sn-28Bi | 52 | 48 | 1.5 | 1.8 | A | A | A | ○ |
| 5 | 0.32:0.4896:0.1904 | Sn-28Bi | 32 | 68 | 1.9 | 2.1 | A | A | A | ○ |
| Comp. Ex. 4 | 0.28:0.5184:0.2016 | Sn-28Bi | 28 | 72 | 2.2 | 2.5 | B | A | A | □ |
| Comp. Ex. 5 | 0.9:0.05:0.05 | Sn-50Bi | 90 | 10 | 0.92 | 1.3 | A | A | B | ▲ |
| 6 | 0.82:0.09:0.09 | Sn-50Bi | 82 | 18 | 0.94 | 1.1 | A | A | A | ○ |
| 7 | 0.43:0.285:0.285 | Sn-50Bi | 43 | 57 | 1.8 | 2.2 | A | A | A | ○ |
| 8 | 0.25:0.375:0.375 | Sn-50Bi | 25 | 75 | 2.0 | 2.8 | A | A | A | ○ |
| Comp. Ex. 6 | 0.21:0.395:0.395 | Sn-50Bi | 21 | 79 | 2.5 | 3.1 | B | B | A | □ |
| Comp. Ex. 7 | 0.73:0.081:0.189 | Sn-70Bi | 73 | 27 | 1.21 | 1.6 | A | A | B | Δ |
| Comp. Ex. 8 | 0.89:0.0462:0.0638 | Sn-58Bi | 89 | 11 | 0.94 | 1.28 | A | A | B | ▲ |
| 9 | 0.79:0.0882:0.1218 | Sn-58Bi | 79 | 21 | 1.19 | 1.59 | A | A | A | ○ |
| 10 | 0.60:0.168:0.232 | Sn-58Bi | 60 | 40 | 1.28 | 1.67 | A | A | A | ○ |
| 11 | 0.39:0.2562:0.3538 | Sn-58Bi | 39 | 61 | 1.8 | 2.1 | A | A | A | ○ |
| 12 | 0.22:0.3276:0.4524 | Sn-58Bi | 22 | 78 | 1.9 | 2.5 | A | A | A | ○ |
| Comp. Ex. 9 | 0.18:0.3444:0.4756 | Sn-58Bi | 18 | 82 | 2.1 | 3.1 | B | B | A | □ |

From Fig. 7, it is evident that the respective compositions of the Examples evaluated as "A" in every category, being initial resistance, maximum resistance, and connection reliability, had, in a ternary plot, a weight ratio (Cu:Sn:Bi) in the region outlined by a quadrilateral with vertices of A (0.37:0.567:0.063), B (0.22:0.3276:0.4524), C (0.79:0.09:0.12), and D (0.89:0.10:0.01),

Also, Comparative Example 7, which, in Fig. 7, is plotted with a "triangle" in a region for compositions with a larger Bi amount relative to the Sn amount, has a larger amount of bismuth deposited in the vias. The conductive resistance of Bi is 78 µΩ·cm, and is remarkably greater than those of Cu (1.69 µΩ·cm), Sn (12.8 µΩ·cm), and Cu-Sn compounds (Cu₃Sn: 17.5 µΩ·cm, Cu₆Sn₅: 8.9 µΩ·cm). Therefore, resistance cannot be sufficiently lowered when the Bi amount relative to the Sn amount is large. Also, connection reliability becomes lower, since resistance changes according to the interspersed state of bismuth.

Also, Comparative Examples 2, 4, 6, and 9, each of which, in Fig. 7, is plotted with a "square" in a region for compositions with a larger Sn amount relative to the Cu amount, exhibit higher initial resistance and higher maximum resistance, due to causes such as: insufficient formation of the plane-to-plane contact portion between the copper particles by the compression; formation of the Sn-Cu compound layer at the contact portion between the copper particles after interdiffusion; and the like.

Also, Comparative Example 1 which, in Fig. 7, is plotted with a "darkened square" in a region for compositions with a smaller Bi amount relative to the Sn amount, exhibits lower connection reliability, because of insufficient formation of the Sn-Cu compound layer for strengthening the plane-to-plane contact portion between the copper particles, the insufficiency being due to decrease in the amount of solder which melts near 140 °C which is the eutectic temperature of the Sn-Bi solder particles, due to the smaller Bi amount. That is, in the case of Comparative Example 1 using the Sn-5Bi solder particles, it can be presumed that, although the example exhibited higher initial resistance and higher maximum resistance due to formation of the plane-to-plane contact portion between the copper particles, the reaction between the Cu and the Sn to form the Sn-Cu compound layer for strengthening the plane-to-plane contact portion did not progress sufficiently because of the melting of the solder particles made difficult due to the smaller Bi amount.

Also, Comparative Examples 3, 5, and 8, each of which, in Fig. 7, was plotted with a "darkened triangle" in a region for compositions with a smaller Sn amount relative to the Cu amount, exhibited lower connection reliability due to there being less of the Sn-Cu compound layer for strengthening the plane-to-plane contact portion between the copper particles, due to the smaller Sn amount relative to the copper particles.

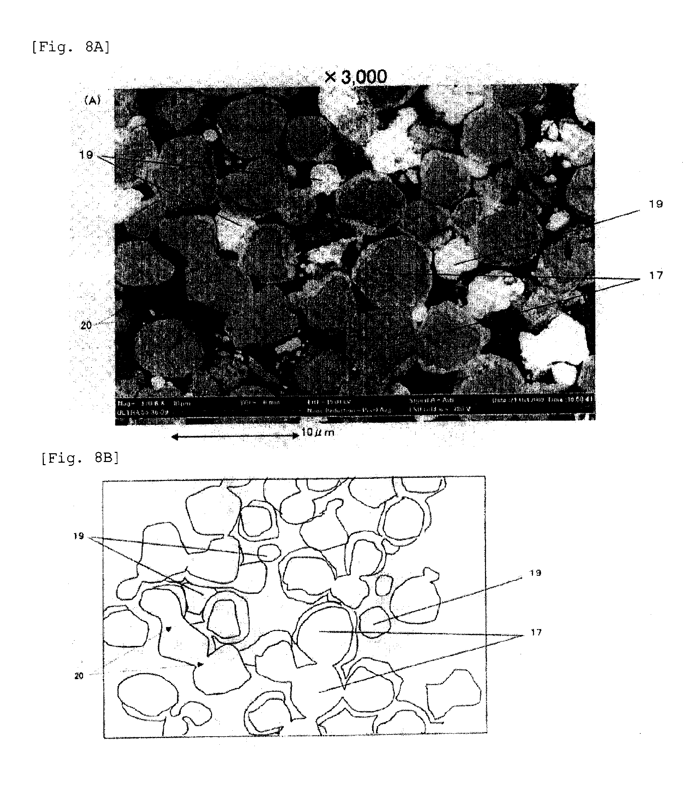

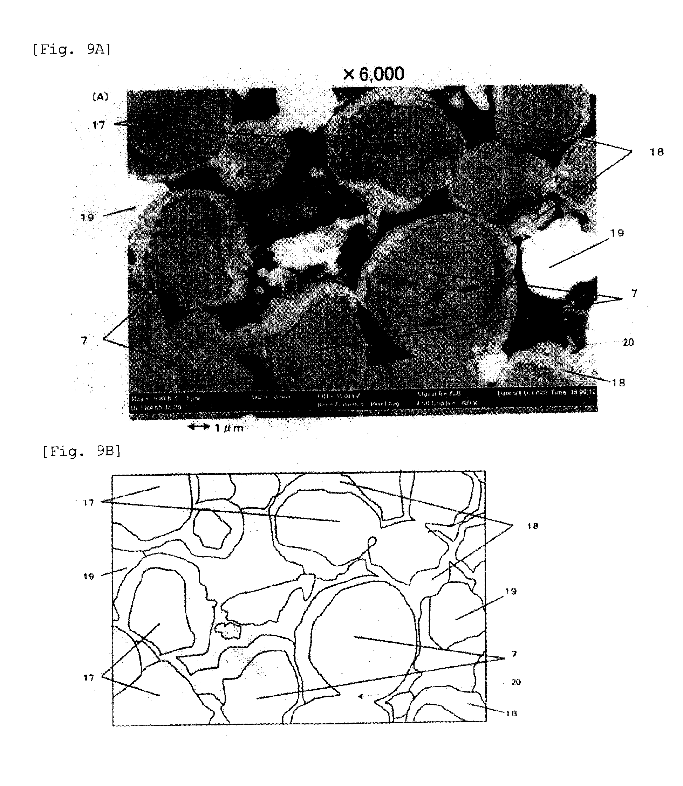

Here, shown are exemplary images created by a scanning electron microscope (SEM), together with their tracings, of a cross section of the via-hole conductor in the multilayer wiring board obtained by using the paste according to Example 10 (weight ratio between the Cu particles and the Sn-58Bi solder being 60:40). Figs. 8A and 9A are SEM images at magnifications of 3000 times and 6000 times, respectively. Also, Figs. 8B and 9B are tracings of Figs. 8A and 9A, respectively.

It is evident from Figs. 8A and 9A that in the obtained via-hole conductor, a number of the Cu particles 7 are highly filled and come into plane-to-plane contact with one another, thereby forming plane-to-plane contact portions 20. It is evident from the above, that conduction paths with low resistance are formed. Also, it is evident that, formed on the surfaces of the links 17a each formed by the Cu particles 7 coming into plane-to-plane contact with one another, are the second metal regions 18 mainly composed of tin (Sn), a tin-copper intermetallic compound, or a tin-copper alloy, each of the regions being formed in a manner such that it extends astride the plane-to-plane contact portion 20. Also, it is evident that the third metal regions 19 mainly composed of Bi which has high resistance, are substantially not in contact with the Cu particles. It is presumed that, with respect to these third metal regions, Bi was deposited at high concentrations due to Sn forming an alloy with Cu on the surface of the Cu particles 7 (e.g., intermetallic compound).

### [Examples 13 to 15]

With respect to Examples 13 to 15, studies were further made on effects of the curing agent depending on kind. Specifically, multilayer wiring boards were produced in the same manner as Examples 1 to 12 by using Sn-58Bi particles as the Sn-Bi solder particles, and then evaluated. Note that further classification was made for the "connection reliability" test. Specifically, with respect to the percent of change from the initial resistance, the percent being 1 % or higher but lower than 5% was evaluated as "S"; the percent being 5% or higher but lower than 10% was evaluated as "A"; and the percent being higher than 10% was evaluated as "B". The results are shown in Table 2. Also, the weight ratio of the composition of Cu:Sn:Bi was 0.56:0.1848:0.2552.

**[Table 2]**

| Example No. | Metallic composition | | | Curing agent | Resistance [mΩ] | Maximum resistance [mΩ] | Evaluation | | |
|---|---|---|---|---|---|---|---|---|---|
| | Solder composition | Cu particles wt%] | Solder amount [wt%] | | | | Initial resistance | Maximum resistance | Connection reliability |
| 13 | Sn-58Bi | 56 | 44 | 2-methylaminoethanol (boiling point: 160) | 2 | 2 | A | A | S |
| 14 | Sn-58Bi | 56 | 44 | 2-diisopropanolamine (boiling point: 250) | 2 | 2 | A | A | S |
| 15 | Sn-58Bi | 56 | 44 | 2,2-dimethylaminoethanol (boilinq point: 135) | 2 | 2 | A | A | A |

As evident from the results in Table 2, the multilayer wiring boards of Examples 13 and 14 which used the curing agent having a boiling point of 139°C being the eutectic temperature of the Sn-58Bi solder, or higher, exhibited a remarkably lower percent of change from the initial resistance in the connection reliability test, and thus exhibited excellent connection reliability. It is considered that reliability is further enhanced when the boiling point of the curing agent is higher than the eutectic temperature of the Sn-Bi solder, since reduction of the oxidation layer present on the surface of the Sn-Bi solder is suppressed, and the second metal regions are sufficiently formed due to volatilization of the curing agent not occurring before the solder melts. Note that the boiling point of the curing agent is preferably 300°C or lower. When it is higher than 300°C, a particular kind of curing agent is required, but there are instances where its reactivity is adversely affected.

### [Industrial Applicability]

According to the present invention, it is possible to further reduce the cost and size of multilayer wiring boards for use in, for example, cell phones, and also further enhance their functionality and reliability Also, in terms of via pastes, proposing a via paste most appropriate for a smaller via diameter and for production of via paste reaction products, contributes to size reduction and reliability enhancement of multilayer wiring boards.

### [Explanation of Reference Numerals]

- 1, 12, 42: wiring
- 2, 14: via-hole conductor
- 5: void or crack
- 7: copper particle
- 11: multilayer wiring board
- 13: insulating resin layer
- 15: metal portion
- 16: resin portion
- 17: first metal region
- 17a: link of copper particles
- 18: second metal region
- 19: third metal region
- 20: plane-to-plane contact portion
- 21: virtual spring
- 23: conductive path
- 25: resin sheet
- 26: protective film
- 27: through-hole
- 28: via paste
- 29: protrusion
- 30: copper foil
- 31: Sn-Bi solder particle
- 32: thermally curable resin component
- 41: wiring board

## Claims

1. A multilayer wiring board comprising:
at least one insulating resin layer;
a plurality of wirings arranged in a manner such that the insulating resin layer is placed between the wirings; and
via-hole conductors provided in a manner such that they penetrate through the insulating resin layer and electrically connect the wirings,
wherein the via-hole conductors each have a metal portion and a resin portion,
the metal portion comprises copper (Cu), tin (Sn), and bismuth (Bi), namely: a first metal region including a link of copper particles, the link electrically connecting the wirings to each other via plane-to-plane contact portions, the plane-to-plane contact portions each being created by the copper particles coming into plane-to-plane contact with each other; a second metal region mainly composed of one or more of tin, a tin-copper alloy, and a tin-copper intermetallic compound; and a third metal region mainly composed of bismuth,
at least a part of the second metal region is in contact with the surface of the link of the copper particles, the surface excluding the area of the plane-to-plane contact portion,
in a ternary plot, the weight ratio of the composition of Cu, Sn, and Bi (Cu:Sn:Bi) in the metal portion, is in a region outlined by a quadrilateral with vertices of A (0.37:0.567:0.063), B (0.22:0.3276:0.4524), C (0.79:0.09:0.12), and D (0.89:0.10:0.01), and
the plane-to-plane contact portion is created by deformations of the adjacent copper particles.

2. The multilayer wiring board in accordance with claim 1, wherein the third metal region is not in contact with the surface of the copper particles.

3. The multilayer wiring board in accordance with claim 1 or 2, wherein the proportion by weight of the copper particles in the via-hole conductor is in the range of 20 to 90%.

4. The multilayer wiring board in accordance with any one of claims 1 to 3, wherein the resin portion comprises a cured epoxy resin.

5. A method for producing a multilayer wiring board, the method comprising the steps of:
perforating a resin sheet covered with a protective film to create through-holes, the perforation starting from the outer side of the protective film;
filling the through-holes with a via paste;
removing the protective film after the filling, to reveal protrusions each being a part of the via paste protruding from the through-hole;
disposing copper foil on a surface of the resin sheet, to cover the protrusions;
compression bonding the metal foil onto the surface of the resin sheet; and
heating the resultant at a predetermined temperature, while maintaining the compression-bonded state,
wherein the via paste comprises copper particles, Sn-Bi solder particles, and a thermally curable resin, and in a ternary plot, the weight ratio of the composition of Cu, Sn, and Bi (Cu:Sn:Bi) is in a region outlined by a quadrilateral with vertices of A (0.37:0.567:0.063), B (0.22:0.3276:0.4524), C (0.79:0.09:0.12), and D (0.89:0.10:0.01),
in the compression bonding step, the via paste is compressed by pressure applied thereto by way of the protrusions having the metal foil disposed thereon, thereby forming a first metal region including a link of the copper particles which are electrically connected via plane-to-plane contact portions each created by deformations of the adjacent copper particles, and
in the heating step: the compressed via paste is heated to melt a part of the Sn-Bi solder particles at a temperature in a range from the eutectic temperature of the Sn-Bi solder particles, to the eutectic temperature plus 10°C; and then, the resultant is heated at a temperature in a range from the eutectic temperature of the Sn-Bi solder particles plus 20°C, to 300°C, thereby forming a second metal region mainly composed of one or more of tin, a tin-copper alloy, and a tin-copper intermetallic compound on the surface of the link of the copper particles, the surface excluding the area of the plane-to-plane contact portion; and a third metal region mainly composed of bismuth.

6. The method for producing a multilayer wiring board in accordance with claim 5, wherein the resin sheet is a sheet having a heat-resistant resin film and a curable adhesive layer that is formed on at least one surface of the heat-resistant resin film.

7. The method for producing a multilayer wiring board in accordance with claim 6, wherein the curable adhesive layer includes an epoxy resin.

8. The method for producing a multilayer wiring board in accordance with claim 5, wherein the thermally curable resin includes an epoxy resin.

9. The method for producing a multilayer wiring board in accordance with claim 8, wherein the epoxy resin contains a curing agent which is an amine compound having at least one hydroxyl group in its molecule.

10. The method for producing a multilayer wiring board in accordance with claim 9, wherein the boiling point of the amine compound is in a range from the eutectic temperature of the Sn-Bi solder particles, to 300°C.

11. A via paste for use in forming via-hole conductors in a multilayer wiring board,
wherein the multilayer wiring board has: at least one insulating resin layer; a plurality of wirings arranged in a manner such that the insulating resin layer is placed between the wirings; and via-hole conductors provided in a manner such that they penetrate through the insulating resin layer and electrically connect the wirings,
the via-hole conductors each have a metal portion and a resin portion,
the metal portion comprises copper (Cu), tin (Sn), and bismuth (Bi), namely: a first metal region including a link of copper particles, the link electrically connecting the wirings to each other via plane-to-plane contact portions, the plane-to-plane contact portions each being created by the copper particles coming into plane-to-plane contact with each other; a second metal region mainly composed of one or more of tin, a tin-copper alloy, and a tin-copper intermetallic compound; and a third metal region mainly composed of bismuth,
at least a part of the second metal region is in contact with the surface of the link of the copper particles, the surface excluding the area of the plane-to-plane contact portion, and
the via paste includes copper particles, Sn-Bi solder particles, and a thermally curable resin, and in a ternary plot, the weight ratio of Cu, Sn, and Bi (Cu:Sn:Bi) is in a region outlined by a quadrilateral with vertices of A (0.37:0.567:0.063), B (0.22:0.3276:0.4524), C (0.79:0.09:0.12), and D (0.89:0.10:0.01).

12. The via paste in accordance with claim 11, wherein the thermally curable resin is an epoxy resin.

13. The via paste in accordance with claim 12, wherein the epoxy resin contains a curing agent which is an amine compound having at least one hydroxyl group in its molecule.

14. The via paste in accordance with claim 13, wherein the boiling point of the amine compound is in a range from the eutectic temperature of the Sn-Bi solder particles, to 300°C.
